# EUROPÄISCHE PATENTSCHRIFT

(11) **EP 1 265 472 B1**
(45) Veröffentlichungstag und Bekanntmachung des Hinweises auf die Patenterteilung: **10.08.2005**
(21) Anmeldenummer: 02360062.0
(22) Anmeldetag: 12.02.2002
(51) Int. Cl.: H05K 7/18, H02B 1/32, H05K 7/20, H02B 1/56

(54) **Elektronikschrank**
Electronic cabinet
Armoire électronique

(30) Priorität: 03.03.2001 DE 10110371
(43) Veröffentlichungstag der Anmeldung: 11.12.2002
(73) Patentinhaber: ALCATEL, 75008 Paris (FR)
(72) Erfinder: Baumruck, Manfred, 1120 Wien (AT)
(74) Vertreter: Brose, Gerhard, Dipl.-Ing.

(56) Entgegenhaltungen:
- DE-U- 29 823 349
- DE-U- 29 908 953
- GB-A- 2 354 317

## Beschreibung

Die Erfindung betrifft einen Elektronikschrank gemäß dem Oberbegriff des Anspruchs 1; (vgl. DE 299 08 953 U1). Elektronikschränke werden häufig als sogenannte 19"-Schränke konfiguriert. Durch diese Normung ergibt sich die Möglichkeit, sehr unterschiedliche Einbauten und Einschübe - auch verschiedener Hersteller - zu kombinieren. Insbesondere werden derartige Elektronikschränke für die Steuerungselektronik von Industrieanlagen benötigt. Regelmäßig enthalten Elektronikschränke mindestens eine Verteilerbox für Sicherungen und einen Lüfter zur Abfuhr der Verlustleistungswärme elektronischer Bauelemente, beispielsweise von Leistungstransistoren. Der Schrank besteht im wesentlichen aus Vertikalstreben und Horizontalstreben, welche skelettartig miteinander verbunden sind. Dabei kommt es darauf an, den vorhandenen engen Raum möglichst optimal auszunutzen. In bezug auf die Sicherungsbox bedeutet das, dass so viele Sicherungen wie möglich in einer Sicherungsbox untergebracht werden müssen. Außerdem sollte der Luftstrom des Lüfters durch die Sicherungsbox nicht mehr als nötig behindert werden. Die Zugänglichkeit zu den Sicherungen muss gewährleistet sein, da ein Sicherungsaustausch jederzeit sehr schnell durchführbar sein muss. Bei bekannten Elektronikschränken ist die Sicherungsbox in Form eines schubladenartigen Kastens von der Frontseite her mittels einer Schienenführung in den Schrank einschiebbar. In diesen Kasten können nicht so viele Sicherungen untergebracht werden, wie aufgrund des Innenvolumens des entsprechenden Schranksegmentes möglich wäre. Außerdem behindert die Kastenform die freie Zirkulation des Luftstromes, so dass der Lüfter nicht unmittelbar benachbart zur Sicherungsbox angeordnet werden kann.

Der Erfindung liegt die Aufgabe zugrunde, einen Elektronikschrank der gattungsgemäßen Art anzugeben, dessen Einbauvolumen optimal ausgenutzt ist, wobei insbesondere die Verteilerbox für die Aufnahme einer größeren Anzahl von Sicherungen zu konzipieren ist. Des weiteren ist anzustreben, dass der Luftstrom nicht behindert oder gar abgeblockt wird und dass die Sicherungen leicht auswechselbar sind.

Die Aufgabe wird mit den kennzeichnenden Merkmalen des Anspruchs 1 gelöst. Durch die Innenmontage der Verteilerbox lässt sich der vorhandene Platz wesentlich besser ausnutzen als bei einem schubladenförmigen Einschubkasten. Die Breite der die Vorderfront begrenzenden Vertikalstreben kann für die seitlichen Begrenzungen der Verteilerbox genutzt werden, so dass die gesamte Öffnungsbreite des Elektronikschrankes für das Einsetzen von Sicherungen zur Verfügung steht. Die Verteilerbox besteht dabei aus derart kurzen, die Schranktiefe nicht vollausnutzenden Blechteilen, dass der Luftstrom des Lüfters hinter der Verteilerbox ungehindert zirkulieren kann. Wenn die normale Konvektion ausreicht, kann auch auf einen Lüfter verzichtet werden. Frontseitig ist die Verteilerbox gegebenenfalls mit einer Abdeckung versehen, die leicht entfernbar ist, um den schnellen Zugang zu den Sicherungen zu gewährleisten.

Gemäß Anspruch 2 kann der Lüfter direkt unterhalb einer Verteilerbox angeordnet sein. Der Luftstrom wird wegen der kurzen Einbautiefe der Verteilerbox nicht behindert, so dass ein vertikaler Abstand zwischen diesen Schrankkomponenten nicht erforderlich ist. Auf diese Weise ergibt sich eine zusätzliche Platzeinsparung.

Die Erfindung wird nachfolgend anhand eines in zwei Figuren dargestellten Ausführungsbeispiels näher erläutert. Es zeigen:
- Fig. 1: eine perspektivische Darstellung eines Elektronikschrankes mit zwei Verteilerboxen für Sicherungen und einem Lüfter und
- Fig. 2: wesentliche Teile einer Verteilerbox.

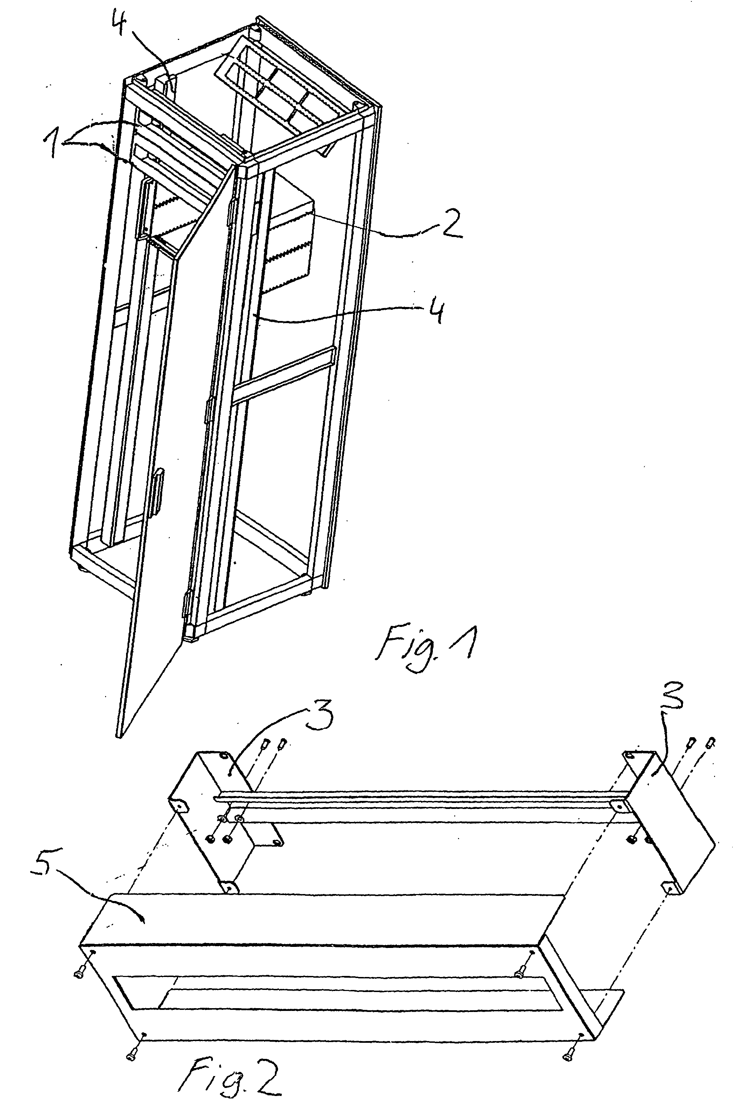

Fig. 1 zeigt einen 1 9"-Schrank mit zwei Verteilerboxen 1 für Sicherungen und einen Lüfter 2. Es ist ersichtlich, dass die Verteilerboxen 1 direkt über dem Lüfter 2 angebracht sind. Die Verteilerboxen 1 und der Lüfter 2 sind dabei nach vorn versetzt, so dass der Luftstrom hinter den Verteilerboxen 1 untergehindert zirkulieren kann. Aus den Fig. 1 und 2 geht hervor, dass die Verteilerboxen 1 mit rückseitigen Blechwinkeln 3 an seitlichen Vertikalstreben 4 des 1 9"-Schrankes befestigt sind. Dadurch ergibt sich die Möglichkeit, die gesamte Breite des 19"-Schrankes für den Sicherungseinbau auszunutzen. Eine frontseitige Abdeckung 5 lässt sich abnehmen, so dass die Sicherungen leicht zugänglich sind.

Die Erfindung beschränkt sich nicht auf das vorstehen angegebene Ausführungsbeispiel. Vielmehr ist eine Anzahl von Varianten denkbar, welche auch bei grundsätzlich anders gearteter Ausführung von den Merkmalen der Erfindung Gebrauch machen.

## Patentansprüche

1. Elektronikschrank mit mindestens einer Verteilerbox (1), insbesondere für Sicherungen, und gegebenenfalls einem Lüfter (2),
**dadurch gekennzeichnet,**
**dass** die Verteilerbox (1) mittels Blechwinkeln (3) an den Innenseiten seitlicher Vertikalstreben (4) des Elektronikschrankes befestigt ist, dass die Einbautiefe der Verteilerbox (1) derart gering ist, dass ein Luftstrom hinter der Verteilerbox (1) ungehindert zirkulieren kann und dass die Verteilerbox (1) gegebenenfalls abnehmbare frontseitige Abdeckungen (5) aufweist.

2. Elektronikschrank nach Anspruch 1,
**dadurch gekennzeichnet,**
**dass** eine Verteiierbox (1) direkt über einem Lüfter (2) angeordnet ist.

## Claims

1. Electronics cabinet with at least one distributor box (1), in particular for fuses, and optionally with a fan (2),
**characterised in that**
the distributor box (1) is fastened, by means of sheet-metal angles (3), to the inner sides of lateral vertical struts (4) belonging to the electronics cabinet; that the depth of installation of the distributor box (1) is so low that a flow of air is able to circulate behind said distributor box (1) in an unhindered manner; and that the distributor box (1) optionally has removable covers (5) on the front side.

2. Electronics cabinet (1) according to claim 1,
**characterised in that**
a distributor box (1) is disposed directly above a fan (2).

## Revendications

1. Armoire électronique comprenant au moins un coffret de distribution (1), notamment pour des fusibles, et éventuellement un ventilateur (2), **caractérisée en ce que** le coffret de distribution (1) est fixé sur les côtés intérieurs des montants verticaux latéraux (4) de l'armoire électronique au moyen d'équerres métalliques (3), qu'un courant d'air peut circuler sans entrave derrière le coffret électrique (1) et que le coffret électrique (1) présente en face avant des couvercles (5) éventuellement amovibles.

2. Armoire électronique selon la revendication. 1, **caractérisée en ce qu'**un coffret de distribution (1) est disposé directement au-dessus d'un ventilateur (2).
